# EUROPÄISCHE PATENTSCHRIFT

(11) **EP 1 955 434 B1**
(45) Veröffentlichungstag und Bekanntmachung des Hinweises auf die Patenterteilung: **22.12.2010**
(21) Anmeldenummer: 06778418.1
(22) Anmeldetag: 07.09.2006
(51) Int. Cl.: H02P 7/29, F01P 7/04, H05K 7/20

(54) **VORRICHTUNG ZUR BEREITSTELLUNG VON PULSWEITENMODULIERTEN LEISTUNGSPULSEN FÜR DEN MOTOR EINES LÜFTERS**
DEVICE FOR SUPPLYING PULSE WIDTH-MODULATED OUTPUT PULSES FOR THE MOTOR OF A FAN
DISPOSITIF POUR FOURNIR DES IMPULSIONS DE PUISSANCE MODULEES EN LARGEUR AU MOTEUR D'UNE SOUFFLANTE

(30) Priorität: 12.10.2005 DE 102005048885
(43) Veröffentlichungstag der Anmeldung: 13.08.2008
(73) Patentinhaber: Brose Fahrzeugteile GmbH & Co. KG, Würzburg, 97076 Würzburg (DE)
(72) Erfinder: MAIER, Erich, 97078 Würzburg (DE)
(74) Vertreter: Reinhard - Skuhra - Weise & Partner GbR
(86) Internationale Anmeldenummer: PCT/EP2006/066097
(87) Internationale Veröffentlichungsnummer: WO 2007/042359

(56) Entgegenhaltungen:
- WO-A-2004/047670
- DE-A- 10 336 376
- US-A1- 2004 007 196
- US-A1- 2005 088 866

## Beschreibung

Die Erfindung betrifft eine Vorrichtung zur Bereitstellung von pulsweitenmodulierten Leistungspulsen für den Motor eines Lüfters.

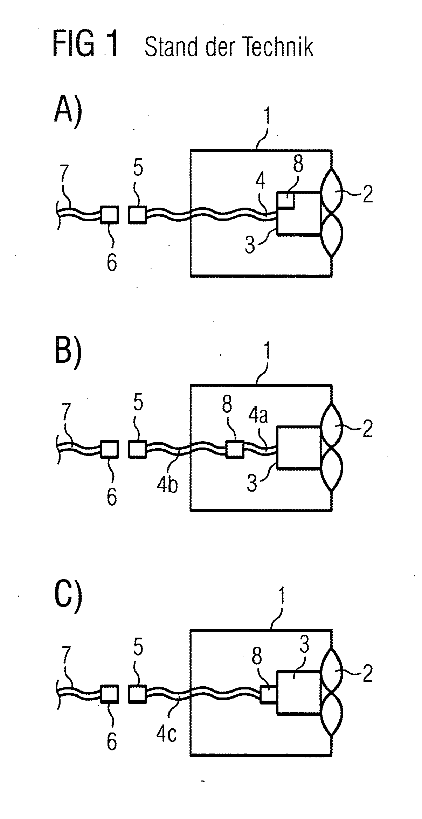

Es ist bereits bekannt, dem Motor eines Lüfters pulsweitenmodulierte Leistungspulse zur Verfügung zu stellen, wobei die pulsweitenmodulierten Leistungspulse unter Verwendung einer Recheneinheit und mindestens einer Leistungsendstufe generiert werden. Die Figur 1 zeigt verschiedene Ausführungsformen gemäß dem Stand der Technik.

In der Figur 1a ist ein Lüfter dargestellt, der ein Lüftergehäuse 1, ein Lüfterrad 2 und einen zum Antrieb des Lüfterrads vorgesehenen Motor aufweist, der in einem Motorgehäuse 3 angeordnet ist. Der Motor wird mit pulsweitenmodulierten Leistungspulsen angesteuert. Die Vorrichtung 8, die diese Leistungspulse bereitstellt, ist ebenfalls innerhalb des Motorgehäuses 3 angeordnet. Das Motorgehäuse 3 ist über ein Verbindungskabel 4 mit einem Stecker 5 verbunden. Dieser ist zur Kontaktierung mit einem Gegenstecker 6 des Bordnetzes 7 eines Fahrzeugs vorgesehen. In einem Steuergerät des Fahrzeugs werden Steuersignale für den Lüfter erzeugt und über das Bordnetz 7, den Gegenstecker 6 und das Verbindungskabel 4 zum Motorgehäuse 3 übertragen.

In der Figur 1b ist ein Lüfter dargestellt, der ein Lüftergehäuse 1, ein Lüfterrad 2, einen zum Antrieb des Lüfterrads vorgesehenen, in einem Motorgehäuse 3 angeordneten Motor und eine Vorrichtung 8 zur Bereitstellung von pulsweitenmodulierten Leistungspulsen aufweist. Dabei ist die Vorrichtung 8 mit dem Motorgehäuse 3 über ein Verbindungskabel 4a und mit einem Stecker 5 über ein Verbindungskabel 4b verbunden. Der Stecker 5 ist zur Kontaktierung mit einem Gegenstecker 6 des Bordnetzes 7 eines Fahrzeugs vorgesehen.

In der Figur Ic ist ein Lüfter gezeigt, der ein Lüftergehäuse 1, ein Lüfterrad 2, einen zum Antrieb des Lüfterrads vorgesehenen, in einem Motorgehäuse 3 angeordneten Motor und eine Vorrichtung 8 zur Bereitstellung von pulsweitenmodulierten Leistungspulsen aufweist. Dabei ist die Vorrichtung 8 an das Motorgehäuse 3 angedockt. Weiterhin ist die Vorrichtung 8 über ein Verbindungskabel 4c mit einem Stecker 5 verbunden. Dieser ist zur Kontaktierung mit einem Gegenstecker 6 des Bordnetzes eines Fahrzeugs vorgesehen.

In der US 2004/0007196 A1 ist eine Vorrichtung beschrieben, welche ein stabförmiges Gehäuse aufweist. In dem stabförmigen Gehäuse sind elektronische Komponenten für die Steuerung eines elektrischen Motors angeordnet. Die Vorrichtung weist des Weiteren kabelgebundene Stecker auf.

Bei allen vorstehend beschriebenen Ausführungsformen gemäss dem Stand der Technik ist nachteilig, dass relativ lange Verbindungsleitungen bzw. Verbindungskabel zum Motorgehäuse geführt werden müssen, welches im mittleren Bereich des Lüfterrades positioniert ist. Diese Leitungsführung erfolgt im Allgemeinen über eine der Kunststoffstreben, die zwischen dem Motorgehäuse und dem Lüftergehäuse vorgesehen sind. Diese

Kunststoffstrebe ist zu diesem Zweck einseitig offen ausgebildet, so dass die Verbindungsleitung in der Kunststoffstrebe geführt werden kann. Nachteilig an einer Verwendung derartiger langer Verbindungsleitungen ist, dass die Leitungsführung aufwendig und unzuverlässig ist. Es treten Leitungsverluste und Scheuerprobleme an den Leitungen auf.

Ferner ist bezüglich der Abdichtung an Durchbrüchen, Schweissstellen und anderen Kontaktstellen grosser Aufwand zu treiben. Weiterhin sind die oben beschriebenen Ausführungsformen autömatisierungsunfreundlich. Ferner tritt eine Antennenwirkung mit hoher Abstrahlung auf und es liegt Einstrahlungsempfindlichkeit vor.

Die Aufgabe der Erfindung besteht darin, die vorstehend beschriebenen Nachteile bekannter Vorrichtungen zu vermeiden.

Diese Aufgabe wird durch eine Vorrichtung mit den in den Patentansprüchen 1 - 13 angegebenen Merkmalen sowie durch einen Lüfter mit den in den Ansprüchen 14 - 17 angegebenen Merkmalen gelöst.

Die Vorteile der Erfindung bestehen insbesondere darin, dass das stabförmige Gehäuse, in welchem die Vorrichtung zur Bereitstellung von pulsweitenmodulierten Leistungspulsen zumindest teilweise untergebracht ist, in einem Lüfter zumindest teilweise zur Überbrückung des Laufradradius des Lüfterrades verwendet werden kann. Im Bereich des Lüfterrades sind folglich im Unterschied zum Stand der Technik keine Verbindungskabel notwendig. Folglich bedarf es keiner aufwendigen Leitungsführung und es treten keine Leitungsverluste und auch keine Scheuerprobleme an Leitungen auf.

Vorzugsweise ist mindestens einer der schmalseitigen Endbereiche des stabförmigen Gehäuses mit einem Stecker verbunden, der integrierter Bestandteil des Gehäuses oder an dieses angespritzt ist. Dieser Stecker ist direkt kontaktierbar mit einem Gegenstecker des Motors und/oder des Bordnetzes. Folglich werden keine losen Stecker, Dichtungen, Leitungen und Schutzschläuche benötigt. Dadurch entfallen Abdichtmaßnahmen an Durchbrüchen; Schweißstellen und anderen Kontaktstellen.

Ist der Stecker gekröpft ausgeführt, wie es im Anspruch 5 angegeben ist, dann können auch Gegenstecker kontaktiert werden, deren Steckrichtung nicht in Achsrichtung des Gehäuses verläuft.

Befindet sich im stabförmigen Gehäuse ein Stanzgitter, dann kann es sich in vorteilhafter Weise bei den Steckerkontakten des Steckers um Bestandteile des Stanzgitters handeln, die aus diesem herausgebogen sind.

Der Laufradbereich des Lüfters wird sicher und stabil überbrückt, wenn das stabförmige Gehäuse unter Verwendung von Befestigungsmitteln am Motorgehäuse und dem Lüftergehäuse befestigt ist. Bei den Befestigungsmitteln kann es sich um Gegenstecker, Schrauben, Clipse oder andere Rastelemente handeln.

Gemäß einer vorteilhaften Weiterbildung der Erfindung können im stabförmigen Gehäuse Zusatzbauelemente untergebracht sein, die bei bekannten Vorrichtungen an einer anderen Stelle angeordnet sind, an welcher enge Einbauverhältnisse vorliegen. Beispielsweise kann es sich bei diesen Zusatzbauelementen um Entstördrosseln handeln, die beim Stand der Technik im Motor oder Stecker angeordnet sind. Durch einen Einbau dieser Entstördrosseln in das stabförmige Gehäuse, in welchem genügend Platz zur Verfügung steht, kann im Motor oder Stecker Platz eingespart werden. Ferner kann es sich bei diesen Zusatzbauelementen um einen Ohmschen Widerstand handeln. Dieser wird beispielsweise benötigt, wenn der Lüfter durch einen Umschaltvorgang, bei welchem der Ohmsche Widerstand zu- bzw. abgeschaltet wird, in verschiedene Drehzahlbereiche umgeschaltet werden kann. Ferner kann auch ein Relais ein Zusatzbauelement sein, das im stabförmigen Gehäuse untergebracht ist.

Ist das stabförmige Gehäuse, wie es im Patentanspruch 14 angegeben ist, mit einem festen Verlängerungsteil verbunden, dann begünstigt dies eine Großserienherstellung des stabförmigen Gehäuses. Denn derartige stabförmige Gehäuse sind universell einsetzbar, wenn sie in Verbindung mit Verlängerungsteilen an unterschiedlich große Lüfter angepasst werden können. Beispielsweise wird ein stabförmiges Gehäuse gefertigt, dessen Länge auf einen am Markt verbreiteten Lüfter mit vergleichsweise kleinem Laufrad abgestimmt ist. Dasselbe stabförmige Gehäuse kann auch bei Lüftern mit größerem Laufrad verwendet werden, wenn es mit einem festen Verlängerungsteil, dessen Länge und Winkelstellung an den jeweils vorhandenen Lüfter angepasst ist, verbunden wird.

Gemäß dem Anspruch 20 kann das stabförmige Gehäuse eine der Streben bekannter Lüfter ersetzen, welche vom Motorgehäuse zum Lüftergehäuse führen.

Weitere Vorteile der Erfindung ergeben sich aus deren beispielhafter Erläuterung anhand der Figuren. Es zeigt
- Figur 1: Ausführungsformen von Lüftern gemäß dem Stand der Technik,
- Figur 2: eine Skizze einer erfindungsgemäßen Vorrichtung zur Bereitstellung von pulsweitenmodulierten Leistungs- pulsen für den Motor eines Lüfters,
- Figur 3: eine Skizze zur Erläuterung eines Lüfters gemäß ei- nem ersten Ausführungsbeispiel für die Erfindung,
- Figur 4: eine Skizze zur Erläuterung eines Lüfters gemäß ei- nem zweiten Ausführungsbeispiel für die Erfindung,
- Figur 5: eine Skizze einer zweiten Ausführungsform einer Vor- richtung zur Bereitstellung von pulsweitenmodulier- ten Leistungspulsen für den Motor eines Lüfters,
- Figur 6: eine Skizze einer dritten Ausführungsform einer Vor- richtung zur Bereitstellung von pulsweitenmodulier- ten Leistungspulsen für den Motor eines Lüfters,
- Figur 7: eine Skizze einer vierten Ausführungsform einer Vor- richtung zur Bereitstellung von pulsweitenmodulier- ten Leistungspulsen für den Motor eines Lüfters,
- Figur 8: eine Skizze einer fünften Ausführungsform einer Vor- richtung zur Bereitstellung von pulsweitenmodulier- ten Leistungspulsen für den Motor eines Lüfters,
- Figur 9: eine Skizze einer sechsten Ausführungsform einer Vorrichtung zur Bereitstellung von pulsweitenmodu- lierten Leistungspulsen für den Motor eines Lüfters,
- Figur 10: eine Skizze einer siebten Ausführungsform einer Vor- richtung zur Bereitstellung von pulsweitenmodulier- ten Leistungspulsen für den Motor eines Lüfters,
- Figur 11: eine Skizze einer achten Ausführungsform einer Vor- richtung zur Bereitstellung von pulsweitenmodulier- ten Leistungspulsen für den Motor eines Lüfters,
- Figur 12: eine Skizze zur Erläuterung eines Ausführungsbei- spiels für die Verbindung einer Vorrichtung zur Be- reitstellung von pulsweitenmodulierten Leistungspul- sen für den Motor eines Lüfters mit dem Motorgehäuse und dem Lüftergehäuse,
- Figur 13: Skizzen zur Erläuterung von Befestigungsmitteln und
- Figur 14: eine Skizze eines Lüfters, bei welchem das stabför- mige Gehäuse zum Ersatz einer Motorstrebe vorgesehen ist.

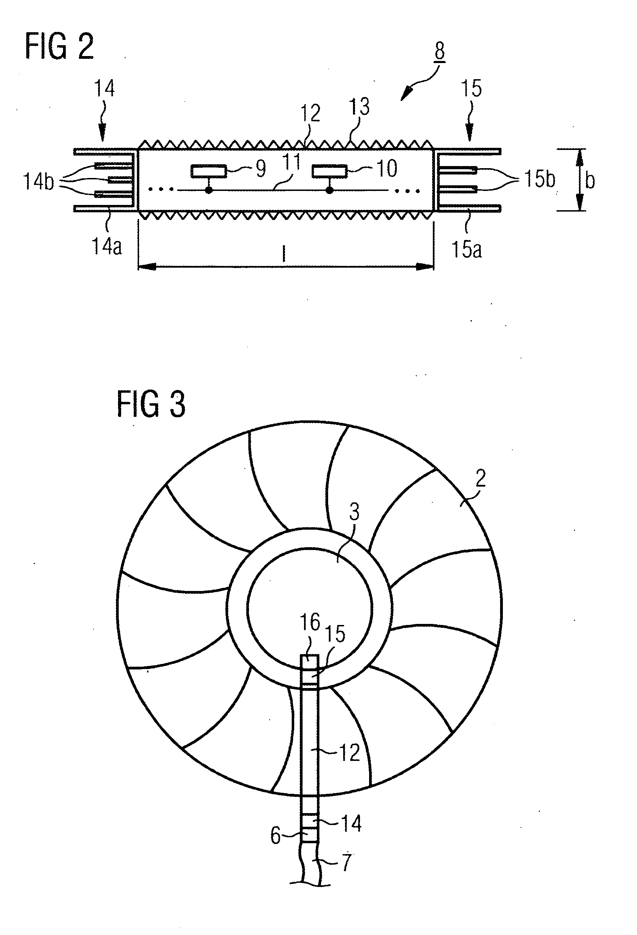

Die Figur 2 zeigt eine Skizze einer erfindungsgemäßen Vorrichtung 8 zur Bereitstellung von pulsweitenmodulierten Leistungspulsen für den Motor eines Lüfters. Die dargestellte Vorrichtung enthält als wesentliche Schaltungsteile eine Recheneinheit 9 und mindestens eine Leistungsendstufe 10, die über ein Leiterbahnen aufweisendes Leiternetzwerk 11 miteinander verbunden sind. Alternativ zu einem Leiternetzwerk kann es sich bei dem Bauteil 11 auch um ein Stanzgitter handeln. Die Recheneinheit 9, die Leistungsendstufe(n) und das Leiternetzwerk sind in einem stabförmigen Gehäuse 12 angeordnet, welches an seinen längsseitigen Außenflächen mit Entwärmungsrippen 13 versehen ist. Die Länge 1 des stabförmigen Gehäuses 12 entspricht mindestens dem Zweifachen der Breite b des stabförmigen Gehäuses. Vorzugsweise ist das stabförmige Gehäuse jedoch möglichst dünn ausgebildet. Beispielsweise kann die Länge des stabförmigen Gehäuses auch dem Zehnfachen der Breite des stabförmigen Gehäuses entsprechen. Auch ein noch größeres Längen- zu Breitenverhältnis ist ohne weiteres möglich. Unter einem stabförmigen Gehäuse im Sinne der Erfindung wird auch ein zumindest annähernd stabförmiges Gehäuse verstanden, bei welchem die Längs- und/oder die Breitseite auch abschnittsweise Verbreiterungen bzw. Ausbeulungen aufweisen kann.

Weiterhin ist an die schmalseitigen Endbereiche des stabförmigen Gehäuses 12 jeweils ein Stecker 14, 15 angespritzt. Alternativ dazu können die Steckergehäuse auch integrierter Bestandteil des Gehäuses 12 sein, d. h. zusammen mit dem Gehäuse in einem Arbeitsgang hergestellt werden. Der Stecker 14 weist ein Steckergehäuse 14a und Steckerkontakte 14b auf. Letztere sind beispielsweise zungenförmige, flache Steckerkontakte. Diese sind mit den im Inneren des Gehäuses 12 verlaufenden Leiterbahnen 11 kontaktiert. Handelt es sich beim Bauteil 11 um Stanzgitter, dann können die zungenförmigen, flachen Steckerkontakte 14b Bestandteile des Stanzgitters und beispielsweise aus diesem herausgebogen sein. Der Stecker 15 weist ein Steckergehäuse 15a und Steckerkontakte 15b auf. Letztere sind beispielsweise zungenförmige, flache Steckerkontakte. Diese sind mit den im Inneren des Gehäuses 12 verlaufenden Leiterbahnen 11 kontaktiert. Handelt es sich beim Bauteil 11 um ein Stanzgitter, dann können die zungenförmigen, flachen Steckerkontakte 15b Bestandteile des Stanzgitters und beispielsweise aus diesem herausgebogen sein.

Der Stecker 14 ist zur Kontaktierung mit einem Gegenstecker des Bordnetzes eines Fahrzeugs vorgesehen, der Stecker 15 zur direkten Kontaktierung mit dem zum Antrieb des Lüfterrades vorgesehenen Motor. Zu diesem Zweck ist beispielsweise in das Motorgehäuse ein Gegenstecker eingebaut, dessen Steckerkontakte zur Herstellung einer Verbindung mit den Steckerkontakten 15b des Steckers 15 kontaktiert werden.

Bei dem stabförmigen Gehäuse 12 mit angespritzten oder integrierten Steckern handelt es sich um ein festes, nicht biegsames Bauteil, das zwischen dem im mittleren Bereich des Lüfterrades positionierten Motor und dem Bordnetz vorgesehen ist und insbesondere so lang ist, dass es großteils oder ganz den Laufradradius des Lüfterrades überbrückt.

Dies ist in der Figur 3 veranschaulicht, welche eine Skizze zur Erläuterung eines Lüfters gemäß einem ersten Ausführungsbeispiel für die Erfindung zeigt. Bei diesem ersten Ausführungsbeispiel ist das Motorgehäuse 3 im mittleren Bereich des Lüfterrades 2 positioniert. Das Motorgehäuse 3 ist mit einem Gegenstecker 16 versehen, der mit dem Stecker 15 des stabförmigen Gehäuses 12 zusammengesteckt ist. Das stabförmige Gehäuse 12 überbrückt den Laufradradius des Lüfterrades 2 vollständig. Der am anderen Ende des stabförmigen Gehäuses 12 vorgesehene Stecker 14 ist mit einem Gegenstecker 6 des Bordnetzes 7 zusammengesteckt. Ausgehend von einem nicht gezeichneten Steuergerät des Fahrzeugs werden Steuersignale über das Bordnetz 7, den Gegenstecker 6 und den Stecker 14 an die im stabförmigen Gehäuse 12 angeordnete Recheneinheit übertragen. Diese setzt die Steuersignale in Treibersignale für den bzw. die Leistungsendstufen um, die ihrerseits pulsweitenmodulierte Leistungspulse für den Motor generieren. Diese werden über den Stecker 15 und den Gegenstecker 16 zum Motor übertragen, der in Abhängigkeit von den pulsweitenmodulierten Leistungspulsen das Lüfterrad 2 antreibt.

Ein wesentlicher Vorteil dieses Ausführungsbeispiels besteht darin, dass zwischen dem Bordnetz bzw. dem Gegenstecker 6 und dem Motorgehäuse 3 keinerlei Verbindungskabel bzw. Verbindungsleitungen notwendig sind. Die gesamte Strecke zwischen dem Gegenstecker 16 am Motorgehäuse 3 und dem Gegenstecker 6 am Bordnetz 7 wird durch das feste, nicht biegsame, stabförmige Gehäuse 12 der Vorrichtung zur Bereitstellung von pulsweitenmodulierten Leistungspulsen überbrückt. Als Befestigungselemente für das stabförmige Gehäuse 12 dienen vorzugsweise die beiden Stecker 15 und 14, die in die Gegenstecker 16 und 6 eingesteckt sind. Es können aber auch andere Befestigungselemente zum Einsatz kommen.

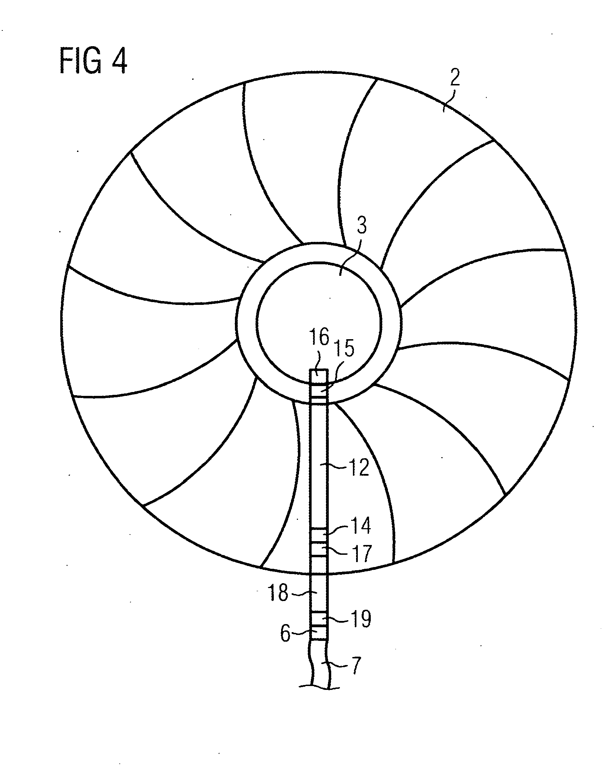

Die Figur 4 zeigt eine Skizze zur Erläuterung eines Lüfters gemäß einem zweiten Ausführungsbeispiel für die Erfindung. Bei diesem zweiten Ausführungsbeispiel ist das Motorgehäuse 3 ebenfalls im mittleren Bereich des Lüfterrades 2 positioniert. Das Motorgehäuse 3 ist mit einem Gegenstecker 16 versehen, der mit dem Stecker 15 des stabförmigen Gehäuses 12 zusammengesteckt ist. Das stabförmige Gehäuse 12 überbrückt einen weiten Teil des Radius des Lüfterrades, wobei der Radius des Lüfterrades größer ist als der Radius des in der Figur 3 gezeigten Lüfterrades. Der am anderen Ende des stabförmigen Gehäuses 12 vorgesehene Stecker 14 ist mit einem Gegenstecker 17 eines Verlängerungsteils 18 zusammengesteckt. Bei dem Verlängerungsteil 18 handelt es sich ebenfalls um ein festes, nicht biegsames, stabförmiges Bauteil, welches zusammen mit dem stabförmigen Gehäuse 12 den Bereich zwischen dem Motorgehäuse 3 und dem Gegenstecker 6 des Bordnetzes 7 und damit auch den Laufradradius überbrückt. Der Stecker 19 des Verlängerungsteils 18 ist mit dem Gegenstecker 6 des Bordnetzes 7 zusammengesteckt. Als Befestigungselemente für das stabförmige Gehäuse 12 und das mit diesem zusammengesteckte Verlängerungsteil 18 dienen die beiden Stecker 15 und 19, die in die Gegenstecker 16 und 6 eingesteckt sind. Es können aber auch andere Befestigungselemente zum Einsatz kommen.

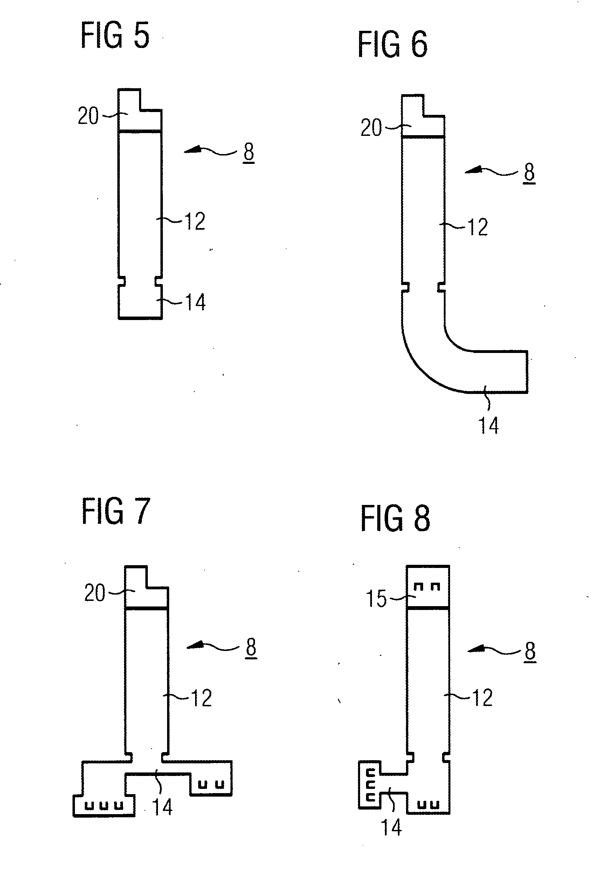

Die Figur 5 zeigt eine Skizze einer zweiten Ausführungsform einer Vorrichtung 8 zur Bereitstellung von pulsweitenmodulierten Leistungspulsen für den Motor eines Lüfters. Bei dieser zweiten Ausführungsform ist einer der schmalseitigen Endbereiche des stabförmigen Gehäuses 12 mit einem Stecker 14 versehen, der an das Gehäuse 12 angespritzt oder integrierter Bestandteil desselben ist. Die Steckrichtung dieses Steckers 14 verläuft ebenso wie bei den oben beschriebenen Vorrichtungen in Längsrichtung des Gehäuses 12. Der Stecker 14 ist zur Kontaktierung mit einem Gegenstecker des Bordnetzes eines Fahrzeugs vorgesehen. Der andere schmalseitige Endbereich des stabförmigen Gehäuses 12 ist mit einem Stecker 20 versehen, der an das Gehäuse 12 angespritzt oder integrierter Bestandteil desselben ist. Dieser Stecker 20 ist abgewinkelt bzw. gekröpft ausgeführt. Er ist mit einem motorseitigen Gegenstecker zusammensteckbar, dessen Steckrichtung von der Längsrichtung des stabförmigen Gehäuses 12 abweicht.

Alternativ zu der in der Figur 5 dargestellten Ausführungsform kann auch der bordnetzseitige Stecker 14 gekröpft bzw. abgewinkelt ausgeführt sein. Ferner können auch beide Stecker 14 und 20 gekröpft bzw. abgewinkelt ausgeführt sein.

Die Figur 6 zeigt eine Skizze einer dritten Ausführungsform einer Vorrichtung 8 zur Bereitstellung von pulsweitenmodulierten Leistungspulsen für den Motor eines Lüfters. Bei dieser dritten Ausführungsform ist einer der schmalseitigen Endbereiche des stabförmigen Gehäuses 12 mit einem Stecker 14 versehen, der an das Gehäuse 12 angespritzt ist. Der Stecker 14 ist gebogen ausgeführt. Die Steckrichtung dieses Steckers 14 verläuft beispielsweise in einem Winkel von 90° zur Längsrichtung des Gehäuses 12. Der Stecker 14 ist zur Kontaktierung mit einem Gegenstecker des Bordnetzes eines Fahrzeugs vorgesehen. Der andere schmalseitige Endbereich des stabförmigen Gehäuses 12 ist mit einem Stecker 20 versehen, der an das Gehäuse 12 angespritzt oder integrierter Bestandteil desselben ist. Dieser Stecker 20 ist abgewinkelt bzw. gekröpft ausgeführt. Er ist mit einem motorseitigem Gegenstecker zusammensteckbar, dessen Steckrichtung von der Längsrichtung des stabförmigen Gehäuses 12 abweicht.

Alternativ zu der in der Figur 6 dargestellten Ausführungsform kann auch oder nur der motorseitige Stecker 20 gebogen ausgeführt sein.

Die Figur 7 zeigt eine Skizze einer vierten Ausführungsform einer Vorrichtung 8 zur Bereitstellung von pulsweitenmodulierten Leistungspulsen für den Motor eines Lüfters. Bei dieser vierten Ausführungsform ist einer der schmalseitigen Endbereiche des stabförmigen Gehäuses 12 mit einem Stecker 14 versehen, der an das Gehäuse 12 angespritzt ist. Bei diesem Stecker 14 handelt es sich um einen Doppelstecker, wie er bei Doppellüftern zur Anwendung kommen kann. Ein Steckerteil dieses Doppelsteckers ist zur Kontaktierung mit einem Gegenstecker des Bordnetzes vorgesehen. Das andere Steckerteil dient zur Kontaktierung mit einem Gegenstecker, der einem zweiten Lüftermotor zugeordnet ist. Die Steckrichtung beider Steckerteile des in der Figur 7 dargestellten Steckers 14 ist die Längsrichtung des stabförmigen Gehäuses 12. Der andere schmalseitige Endbereich des stabförmigen Gehäuses 12 ist mit einem Stecker 20 versehen, der an das Gehäuse 12 angespritzt oder integrierter Bestandteil desselben ist. Dieser Stecker 20 ist abgewinkelt bzw. gekröpft ausgeführt. Er ist mit einem motorseitigem Gegenstecker zusammensteckbar, dessen Steckrichtung von der Längsrichtung des stabförmigen Gehäuses 12 abweicht.

Die Figur 8 zeigt eine Skizze einer fünften Ausführungsform einer Vorrichtung 8 zur Bereitstellung von pulsweitenmodulierten Leistungspulsen für den Motor eines Lüfters. Bei dieser fünften Ausführungsform ist einer der schmalseitigen Endbereiche des stabförmigen Gehäuses 12 mit einem Stecker 14 versehen, der an das Gehäuse 12 angespritzt ist. Bei diesem Stecker 14 handelt es sich um einen Doppelstecker, wie er bei Doppellüftern zur Anwendung kommen kann. Ein Steckerteil dieses Doppelsteckers ist zur Kontaktierung mit einem Gegenstecker des Bordnetzes vorgesehen. Das andere Steckerteil dient zur Kontaktierung mit einem Gegenstecker, der einem zweiten Lüfterrad zugeordnet ist. Die Steckrichtung eines Steckerteils des Steckers 14 verläuft in Längsrichtung des stabförmigen Gehäuses 12. Die Steckrichtung des anderen Steckerteils des Steckers 14 verläuft beispielsweise in einem Winkel von 90° zur Längsrichtung des stabförmigen Gehäuses 12. Der andere schmalseitige Endbereich des stabförmigen Gehäuses 12 ist mit einem Stecker 15 versehen, der an das Gehäuse 12 angespritzt oder integrierter Bestandteil desselben ist. Die Steckrichtung des Steckers 15 verläuft in Längsrichtung des stabförmigen Gehäuses 12. Der Stecker 15 ist mit einem motorseitigen Gegenstecker zusammensteckbar, dessen Steckrichtung ebenfalls die Längsrichtung des stabförmigen Gehäuses 12 ist.

Alternativ zu der in der Figur 8 dargestellten Ausführungsform kann der Stecker 15 auch gekröpft bzw. abgewinkelt ausgeführt sein.

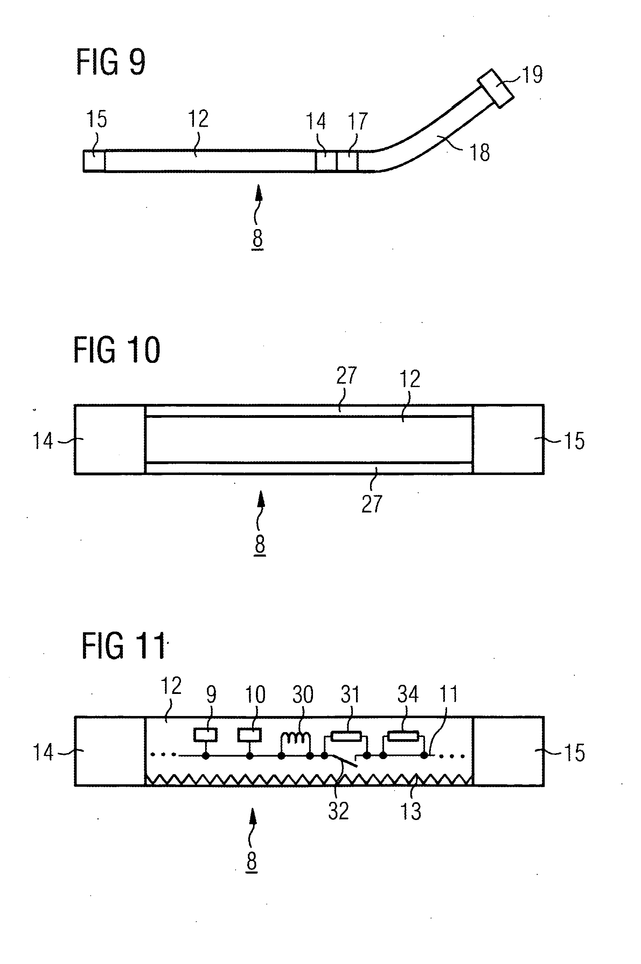

Die Figur 9 zeigt eine Skizze einer sechsten Ausführungsform einer Vorrichtung 8 zur Bereitstellung von pulsweitenmodulierten Leistungspulsen für den Motor eines Lüfters. Bei dieser achten Ausführungsform ist einer der schmalseitigen Endbereiche des stabförmigen Gehäuses 12 mit einem Stecker 14 versehen, der an das Gehäuse 12 angespritzt oder integrierter Bestandteil desselben ist. Die Steckrichtung dieses Steckers 14 verläuft in Längsrichtung des Gehäuses 12. Der Stecker 14 ist zur Kontaktierung mit einem Gegenstecker 17 eines festen, nicht biegsamen Verlängerungsteils 18 vorgesehen. Das Verlängerungsteil 18 ist gebogen ausgeführt und in seinem anderen Endbereich mit einem Stecker 19 versehen. Dieser dient zur Kontaktierung mit einem Gegenstecker des Bordnetzes, wobei die Steckrichtung des Gegensteckers des Bordnetzes von der Längsrichtung des stabförmigen Gehäuses 12 abweicht und wobei der Abstand zwischen dem Stecker 14 des stabförmigen Gehäuses 12 und dem Gegenstecker des Bordnetzes durch ein zweites Bauteil überbrückt werden muss. Der andere schmalseitige Endbereich des stabförmigen Gehäuses 12 ist mit einem Stecker 15 versehen, der an das Gehäuse 12 angespritzt oder integrierter Bestandteil desselben ist. Die Steckrichtung des Steckers 15 stimmt mit der Längsrichtung des stabförmigen Gehäuses 12 überein. Der Stecker 15 ist mit einem motorseitigen Gegenstecker zusammensteckbar, dessen Steckrichtung ebenfalls die Längsrichtung des stabförmigen Gehäuses 12 ist.

Alternativ zu der in der Figur 9 dargestellten Ausführungsform kann der Stecker 15 auch gekröpft bzw. abgewinkelt ausgeführt sein.

Die Figur 10 zeigt eine weitere Ausführungsform für eine Vorrichtung zur Bereitstellung von pulsweitenmodulierten Leistungspulsen für den Motor eines Lüfters. Bei dieser weiteren Ausführungsform ist das stabförmige Gehäuse 12 in seinen schmalseitigen Endbereichen mit Steckern 14, 15 versehen, wobei der Stecker 14 zur Kontaktierung mit einem Gegenstecker des Bordnetzes und der Stecker 15 zur Kontaktierung mit einem am Motorgehäuse vorgesehenen Gegenstecker vorgesehen ist. Ferner ist bei dieser weiteren Ausführungsform das Gehäuse 12 von einer Metallummantelung 27 umgeben. Der Vorteil dieser Metallummantelung, die auch bei allen oben beschriebenen Ausführungsformen bzw. Ausführungsbeispielen vorgesehen sein kann, besteht darin, dass im Betrieb keine Antennenwirkung mit hoher Abstrahlung auftritt und auch die Einstrahlungsempfindlichkeit stark reduziert ist.

Die Figur 11 zeigt eine weitere Ausführungsform einer Vorrichtung zur Bereitstellung von pulsweitenmodulierten Leistungspulsen für den Motor eines Lüfters. Bei dieser weiteren Ausführungsform weist das stabförmige Gehäuse 12 in seinen schmalseitigen Endbereichen Stecker 14 und 15 auf. Der Stecker 14 dient zur Kontaktierung mit einem Gegenstecker des Bordnetzes, der Stecker 15 ist zur Kontaktierung mit einem Gegenstecker am Motorgehäuse vorgesehen. Das stabförmige Gehäuse 12 ist mit nach innen gerichteten Entwärmungsrippen 13 versehen. Weiterhin sind innerhalb des Gehäuses 12 außer der Recheneinheit 9, mindestens einer Leistungsendstufe 10 und dem Stanzgitter bzw. Leiternetzwerk 11 mindestens eine Entstördrossel 30 und ein Ohmscher Widerstand 31 vorgesehen. Die Entstördrossel 30 ist üblicherweise im Motor oder Stecker vorgesehen. Da dort jedoch enge Einbauverhältnisse vorliegen, ist die Entstördrossel im stabförmigen Gehäuse 12 positioniert, wo hinreichend Platz zur Verfügung steht. Der Ohmsche Widerstand 31 ist mittels eines Schalters 32 zu- und abschaltbar, um einen Lüfter zu realisieren, der in zwei Drehzahlbereichen arbeiten kann. Weiterhin kann im stabförmigen Gehäuse 12 auch ein Relais 34 untergebracht sein.

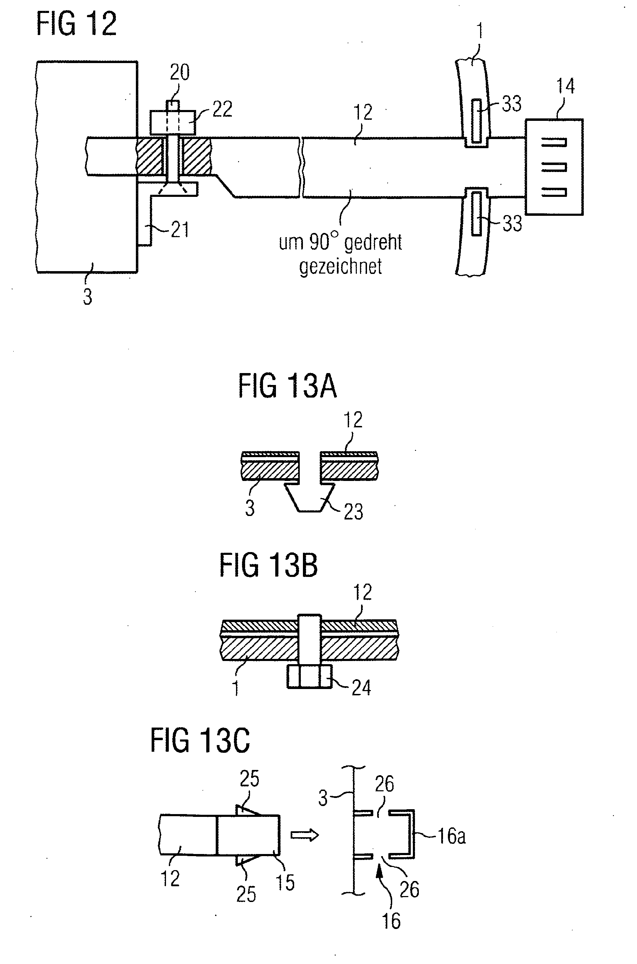

Die Figur 12 zeigt eine Skizze zur Erläuterung eines weiteren Ausführungsbeispiels für die Verbindung einer Vorrichtung zur Bereitstellung von pulsweitenmodulierten Leistungspulsen für den Motor eines Lüfters mit dem Motorgehäuse 3 und dem Lüftergehäuse 1. Bei diesem weiteren Ausführungsbeispiel ist das stabförmige Gehäuse 12 in einem seiner schmalseitigen Endbereiche mit einem Stecker 14 versehen, der an das Gehäuse 12 angespritzt oder integrierter Bestandteil desselben ist. Dieser Stecker 14 ist zur Kontaktierung mit einem Gegenstecker des Bordnetzes vorgesehen. Im anderen schmalseitigen Endbereich ist das stabförmige Gehäuse 12 unter Verwendung von Schrauben 20 mit einer am Motorgehäuse 3 vorgesehenen Lasche 21 und einem Befestigungsring 22 verschraubt. Der Befestigungsring 22 ist an der Hutze des Lüftergehäuses 1 angebracht. Das Lüftergehäuse weist einen Clip 33 auf, welcher in eine Nut des stabförmigen Gehäuses 12 eingreift. In der Figur 12 ist der rechte Teil der Zeichnung zur Veranschaulichung um 90° gedreht dargestellt.

Die Figur 13 zeigt Skizzen zur Erläuterung von weiteren Befestigungsmitteln, mittels derer das stabförmige Gehäuse 12 am Motorgehäuse oder am Lüftergehäuse befestigt werden kann. Diese Befestigungsmittel sind am Außenumfang des stabförmigen Gehäuses 12 angeordnet, vorzugsweise in der Nähe von dessen schmalseitigen Endbereichen.

Gemäß der Figur 13a ist am Außenumfang des stabförmigen Gehäuses 12 ein tannenbaumförmiger Rasthaken 23 vorgesehen, mittels dessen das stabförmige Gehäuse 12 am Motorgehäuse 3 befestigt ist. Gemäß der Figur 13b erfolgt die Befestigung des stabförmigen Gehäuses 12 am Lüftergehäuse 1 mittels Schrauben 24. Gemäß der Figur 13c ist das stabförmige Gehäuse 12 an einem seiner schmalseitigen Endbereiche mit einem Stecker 15 versehen, der an seinen Außenseiten Rastnasen 25 aufweist. Wird dieser Stecker 15 in einen am Motorgehäuse 3 vorgesehenen Gegenstecker gesteckt, dann rasten die Rastnasen 25 in Rastnuten 26 ein, die im Steckergehäuse 16a des Gegensteckers 16 vorgesehen sind.

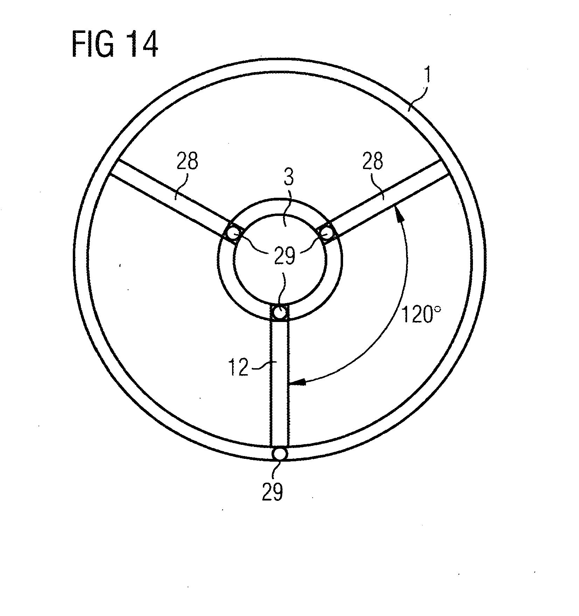

Die Figur 14 zeigt ein weiteres Ausführungsbeispiel zur Erläuterung eines Lüfters gemäß der Erfindung, gemäß welchem eine der Streben, mittels derer das Motorgehäuse befestigt ist, durch das stabförmige Gehäuse 12 ersetzt ist. Dabei ist in der Figur das Motorgehäuse 3 dargestellt, an welchem mittels Schrauben 29 zwei herkömmliche Streben 28 und das stabförmige Gehäuse 12 befestigt sind. Die äußere Form des stabförmigen Gehäuses 12 entspricht dabei annähernd der äußeren Form einer Strebe 28. In ihrem jeweils anderen Endbereich ist das stabförmige Gehäuse 12 mittels weiterer Schrauben oder anderer Verbindungselemente am Lüftergehäuse 1 befestigt. Bei diesem Ausführungsbeispiel sind die beiden Streben 28 und das stabförmige Gehäuse 12 jeweils um einen beliebigen Winkel, beispielsweise um einen Winkel von 120° gegeneinander versetzt. Da bei diesem Ausführungsbeispiel das stabförmige Gehäuse 12 als Ersatz für eine Strebe verwendet wird, wird für das stabförmige Gehäuse 12 kein zusätzlicher Platz am Motorgehäuse und am Lüftergehäuse bzw. an dessen Hutze benötigt.

Ein weiterer Vorteil eines Lüfters, der eine Vorrichtung gemäß der Erfindung aufweist, besteht darin, dass das stabförmige Gehäuse direkt im Luftstrom des Lüfterrads angeordnet werden kann, so dass eine gute Abführung der mittels der Leistungsendstufen erzeugten Wärme gegeben ist. Weiterhin tritt nur eine geringe Luftblockierung auf, da die im Luftstrom liegende Fläche des stabförmigen Gehäuses klein ist. Ein weiterer Vorteil der Erfindung besteht in einer verbesserten Automatisierbarkeit der Herstellung eines Lüfters, da keine aufwendige Verlegung bzw. Führung von Verbindungskabeln notwendig ist.

Alternativ kann bei allen oben genannten Ausführungsbeispielen die Steckverbindung 15/16 am Motor durch eine Schweißverbindung von Kontaktlaschen des stabförmigen Gehäuses mit jeweils zugehörigen Leiterbahnen im Motor ersetzt sein.

## Patentansprüche

1. Vorrichtung zur Bereitstellung von pulsweitenmodulierten Leistungspulsen für den Motor eines Lüfters,
- mit einem stabförmigen Gehäuse (12), das zwei schmalseitige Endbereiche aufweist, wobei die Länge (I) des stabförmigen Gehäuses (12) mindestens dem Zweifachen der Breite (b) des stabförmigen Gehäuses (12) entspricht, und insbesondere eine Form aufweist, die den Streben (28) ähnelt, mit denen das Motorgehäuse (3) am Lüftergehäuse (1) befestigt ist,
- mit einer Recheneinheit (9),
- mit mindestens einer Leistungsendstufe (10),
- mit einem Stanzgitter (11),
wobei
- die Recheneinheit (9), die Leistungsendstufe (10) und das Stanzgitter in dem stabförmigen Gehäuse (12) angeordnet sind,
- mindestens einer der schmalseitigen Endbereiche des Gehäuses (12) einen Stecker (14, 15) mit entsprechendem Steckergehäuse (14a, 15a) und Steckerkontakt (14a, 15a) aufweist,
- die Steckerkontakte (14a, 15a) des Steckers (14, 15) Bestandteile des Stanzgitters (11) sind oder die Steckerkontakte (14a, 15a) des Steckers (14, 15) mit dem Stanzgitter (11) verbunden sind, und
- das stabförmige Gehäuse (12) mit dem einen Stecker (14) an die Versorgung, insbesondere einem Bordnetz (7), und mit dem anderen Stecker (15) an den Motor angeschlossen wird.

2. Vorrichtung nach einem der vorhergehenden Ansprüche,
**dadurch gekennzeichnet, dass**
das Steckergehäuse (14a, 15a) Bestandteil des stabförmigen Gehäuses (12) ist.

3. Vorrichtung nach einem der Ansprüche 1 der 2,
**dadurch gekennzeichnet, dass**
mindestens einer der schmalseitigen Endbereiche des Gehäuses (12) einen gekröpften Stecker (20) aufweist.

4. Vorrichtung nach einem der vorhergehenden Ansprüche,
**dadurch gekennzeichnet, dass**
das stabförmige Gehäuse (12) an seinem Aussenumfang Befestigungsmittel (14, 15, 23, 24, 25) aufweist.

5. Vorrichtung nach Anspruch 4,
**dadurch gekennzeichnet, dass**
die Befestigungsmittel die Stecker sind oder Rastmittel oder Befestigungslaschen aufweisen.

6. Vorrichtung nach einem der vorhergehenden Ansprüche,
**dadurch gekennzeichnet, dass**
das stabförmige Gehäuse (12) mit einer Metallummantelung (27) versehen ist.

7. Vorrichtung nach einem der vorhergehenden Ansprüche,
**dadurch gekennzeichnet, dass**
im stabförmigen Gehäuse (12) weiterhin mindestens ein Zusatzbauelement (30, 31, 34) enthalten ist.

8. Vorrichtung nach Anspruch 7,
**dadurch gekennzeichnet, dass**
ein Zusatzbauelement eine Entstördrossel (30) ist.

9. Vorrichtung nach Anspruch 7 oder 8,
**dadurch gekennzeichnet, dass**
ein Zusatzbauelement ein Ohmscher Widerstand (31) und/oder ein Relais (34) ist.

10. Vorrichtung nach einem der vorhergehenden Ansprüche,
**dadurch gekennzeichnet, dass**
die Vorrichtung als Lüfter ausgebildet ist,
mit einem Lüftergehäuse (1),
mit einem Lüfterrad (2),
mit einem Motor, der in einem Motorgehäuse (3) angeordnet ist.

11. Vorrichtung nach Anspruch 10,
**dadurch gekennzeichnet, dass**
mindestens einer der schmalseitigen Endbereiche des stabförmigen Gehäuses (12) ohne Verwendung eines Verbindungskabels mit dem Motorgehäuse (3) kontaktiert ist.

12. Vorrichtung nach Anspruch 10 der 11,
**dadurch gekennzeichnet, dass**
der mit dem Motorgehäuse (3) kontaktierte schmalseitige Endbereich des stabförmigen Gehäuses den Stecker aufweist, der mit einem Gegenstecker (16) des Motorgehäuses (3) direkt kontaktiert ist.

13. Vorrichtung nach einem der Ansprüche 10-12,
**dadurch gekennzeichnet, dass**
der Motor im mittleren Bereich des Lüfterrades (2) positioniert ist und das stabförmige Gehäuse (12) den Laufradradius des Lüfterrades (2) vollständig oder grossteils überbrückt.

14. Lüfter nach einem der Ansprüche 1-13,
**dadurch gekennzeichnet, dass**
der Motor im mittleren Bereich des Lüfterrades (2) positioniert ist, das stabförmige Gehäuse (12) mit einem festen Verlängerungsteil (18) verbunden ist und das stabförmige Gehäuse zusammen mit dem damit verbundenen festen Verlängerungsteil den Laufradradius des Lüfterrades überbrückt.

15. Lüfter nach einem der Ansprüche 1-14,
**dadurch gekennzeichnet, dass**
das Motorgehäuse (3) mit dem Lüftergehäuse (1) mittels Streben (28) verbunden ist und das stabförmige Gehäuse (12) als Strebe dient.

16. Lüfter nach einem der Ansprüche 1-15
**dadurch gekennzeichnet, dass**
das Motorgehäuse (3) mittels einer Lasche und eines Befestigungsringes am Lüftergehäuse befestigt ist und das stabförmige Gehäuse an der Motorlasche und dem Befestigungsring befestigt ist.

17. Lüfter nach Anspruch 16,
**dadurch gekennzeichnet,**
**dass** das stabförmige Gehäuse mit der Motorlasche und dem Befestigungsring verschraubt ist.

## Claims

1. Apparatus for supplying pulse-width-modulated power pulses for the motor of a fan,
- having a rod-like housing (12) which has two narrow-side end regions, with the length (1) of the rod-like housing (12) corresponding at least to twice the width (b) of the rod-like housing (12), and in particular having a shape which resembles the struts (28) by way of which the motor housing (3) is fixed to the fan housing (1),
- having a computation unit (9),
- having at least one power output stage (10),
- having a leadframe (11),
with
- the computation unit (9), the power output stage (10) and the leadframe being arranged in the rod-like housing (12),
- at least one of the narrow-side end regions of the housing (12) having a plug (14, 15) with a corresponding plug housing (14a, 15a) and plug contact (14a, 15a),
- the plug contacts (14a, 15a) of the plug (14, 15) being constituent parts of the leadframe (11) or the plug contacts (14a, 15a) of the plug (14, 15) being connected to the leadframe (11), and
- the rod-like housing (12) being connected to the power supply means, in particular an on-board electrical system (7), by way of one plug (14) and to the motor by way of the other plug (15).

2. Apparatus according to Claim 1,
**characterized in that**
the plug housing (14a, 15a) is a constituent part of the rod-like housing (12).

3. Apparatus according to either of Claims 1 and 2,
**characterized in that**
at least one of the narrow-side end regions of the housing (12) has an angled plug (20).

4. Apparatus according to one of the preceding claims,
**characterized in that**
the rod-like housing (12) has fixing means (14, 15, 23, 24, 25) on its outer circumference.

5. Apparatus according to Claim 4,
**characterized in that**
the fixing means are the plugs or have latching means or fixing lugs.

6. Apparatus according to one of the preceding claims,
**characterized in that**
the rod-like housing (12) is provided with a metal sheath (27).

7. Apparatus according to one of the preceding claims,
**characterized in that**
at least one additional component (30, 31, 34) is also contained in the rod-like housing (12).

8. Apparatus according to Claim 7,
**characterized in that**
an additional component is an interference-suppression coil (30).

9. Apparatus according to Claim 7 or 8,
**characterized in that**
an additional component is a non-reactive resistor (31) and/or a relay (34).

10. Apparatus according to one of the preceding claims,
**characterized in that**
the apparatus is in the form of a fan,
having a fan housing (1),
having a fan impeller (2),
having a motor which is arranged in a motor housing (3) .

11. Apparatus according to Claim 10,
**characterized in that**
at least one of the narrow-side end regions of the rod-like housing (12) is contact-connected to the motor housing (3) without using a connecting cable.

12. Apparatus according to Claim 10 or 11,
**characterized in that**
**that** narrow-side end region of the rod-like housing which is contact-connected to the motor housing (3) is fitted with the plug which is directly contact-connected to a mating plug (16) of the motor housing (3).

13. Apparatus according to one of Claims 10-12,
**characterized in that**
the motor is positioned in the central region of the fan impeller (2) and the rod-like housing (12) completely or largely bridges the radius of the fan impeller (2).

14. Fan according to one of Claims 1-13,
**characterized in that**
the motor is positioned in the central region of the fan impeller (2), the rod-like housing (12) is connected to a fixed extension part (18), and the rod-like housing, together with the fixed extension part which is connected to it, bridges the radius of the fan impeller.

15. Fan according to one of Claims 1-14,
**characterized in that**
the motor housing (3) is connected to the fan housing (1) by means of struts (28), and the rod-like housing (12) serves as a strut.

16. Fan according to one of Claims 1-15,
**characterized in that**
the motor housing (3) is fixed to the fan housing by means of a lug and a fixing ring, and the rod-like housing is fixed to the motor lug and to the fixing ring.

17. Fan according to Claim 16,
**characterized in that**
the rod-like housing is screwed to the motor lug and to the fixing ring.

## Revendications

1. Dispositif pour fournir des impulsions de puissance modulées en largeur au moteur d'une soufflante, comprenant :
- un boîtier en forme de baguette (12), qui présente deux parties terminales à petit côté, la longueur (1) du boîtier en forme de baguette (12) correspondant au moins au double de la largeur (b) du boîtier en forme de baguette (12), et possède notamment une forme qui ressemble aux entretoises (28) à l'aide desquelles le carter de moteur (3) est fixé au carter de ventilateur (1),
- une unité de calcul (9),
- au moins un étage final de puissance (10),
- un grillage estampé (11)
dans lequel
l'unité de calcul (9), l'étage final de puissance (10) et le grillage estampé sont disposés dans le boîtier en forme de baguette (12),
au moins une des parties terminales à petit côté du boîtier (12) présente un connecteur (14, 15) doté d'un boîtier de connexion (14a, 15a) et d'un contact de connexion (14a, 15a) correspondants,
les contacts de connexion (14a, 15a) du connecteur (14, 15) sont des composants du grillage estampé (11) ou les contacts de connexion (14a, 15a) du connecteur (14, 15) sont reliés au grillage estampé (11), et
le boîtier en forme de baguette (12) est raccordé à l'alimentation, notamment à un réseau de bord (7), à l'aide du premier connecteur (14), et au moteur à l'aide de l'autre connecteur (15).

2. Dispositif selon l'une des revendications précédentes, **caractérisé en ce que** le boîtier de connexion (14a, 15a) est un composant du boîtier en forme de baguette (12).

3. Dispositif selon l'une des revendications 1 à 2, **caractérisé en ce que** au moins une des parties terminales à petit côté du boîtier (12) présente un connecteur coudé (20).

4. Dispositif selon l'une des revendications précédentes, **caractérisé en ce que** le boîtier en forme de baguette (12) présente des moyens de fixation (14, 15, 23, 24, 25) sur son pourtour extérieur.

5. Dispositif selon la revendication 4, **caractérisé en ce que** les moyens de fixation constituent les connecteurs ou présentent des moyens d'enclenchement ou des pattes de fixation.

6. Dispositif selon l'une des revendications précédentes, **caractérisé en ce que** le boîtier en forme de baguette (12) est doté d'un revêtement métallique (27).

7. Dispositif selon l'une des revendications précédentes, **caractérisé en ce que** le boîtier en forme de baguette (12) contient également au moins un élément structurel complémentaire (30, 31, 34).

8. Dispositif selon la revendication 7, **caractérisé en ce que** l'élément structurel complémentaire est une bobine d'antiparasitage (30).

9. Dispositif selon la revendication 7 ou 8, **caractérisé en ce que** l'élément structurel complémentaire est une résistance ohmique (31) et/ou un relais (34).

10. Dispositif selon l'une des revendications précédentes, **caractérisé en ce que** le dispositif est conçu comme une soufflante présentant un carter de soufflante (1), une roue de soufflante (2), un moteur, qui est disposé dans un carter de moteur (3).

11. Dispositif selon la revendication 10, **caractérisé en ce qu'**au moins une des parties terminales à petit côté du boîtier en forme de baguette (12) est mise en contact avec le carter de moteur (3) sans utilisation d'un câble de jonction.

12. Dispositif selon la revendication 10 ou 11, **caractérisé en ce que** la partie terminale à petit côté du boîtier en forme de baguette, mise en contact avec le carter de moteur (3), présente le connecteur qui est directement mis en contact avec un connecteur opposé (16) du carter de moteur (3).

13. Dispositif selon l'une des revendications 10 à 12, **caractérisé en ce que** le moteur est positionné dans la région centrale de la roue de soufflante (2) et le boîtier en forme de baguette (12) couvre entièrement ou en grande partie le rayon du rotor de la roue de soufflante (2).

14. Soufflante selon l'une des revendications 1 à 13, **caractérisée en ce que** le moteur est positionné dans la région centrale de la roue de soufflante (2), le boîtier en forme de baguette (12) est relié à une rallonge fixe (18) et le boîtier en forme de baguette, conjointement avec la rallonge fixe qui y est reliée, couvre le rayon du rotor de la roue de soufflante.

15. Soufflante selon l'une des revendications 1 à 14, **caractérisée en ce que** le carter de moteur (3) est relié au boîtier de soufflante (1) à l'aide d'entretoises (28) et le boîtier en forme de baguette (12) sert d'entretoise.

16. Soufflante selon l'une des revendications 1 à 15, **caractérisée en ce que** le carter de moteur (3) est fixé au boîtier de soufflante à l'aide d'une patte et d'une bague de fixation et le boîtier en forme de baguette est fixé à la patte du moteur et à la bague de fixation.

17. Soufflante selon la revendication 16, **caractérisée en ce que** le boîtier en forme de baguette est vissé à la patte du moteur et à la bague de fixation.
